# EUROPÄISCHE PATENTSCHRIFT

(11) **EP 2 189 797 B1**
(45) Veröffentlichungstag und Bekanntmachung des Hinweises auf die Patenterteilung: **04.07.2018**
(21) Anmeldenummer: 09175171.9
(22) Anmeldetag: 05.11.2009
(51) Int. Cl.: G01R 1/067, G01R 19/155

(54) **Spannungsprüfvorrichtung für Flüssigkeiten**
Voltage testing apparatus for fluids
Dispositif de contrôle de la tension pour liquides

(30) Priorität: 24.11.2008 DE 102008058770
(43) Veröffentlichungstag der Anmeldung: 26.05.2010
(73) Patentinhaber: Eswe Versorgungs AG, 65189 Wiesbaden (DE)
(72) Erfinder: Canterino, Fabio, 65366, Geisenheim (DE); Fuchs, Markus, 65195, Wiesbaden (DE); Klein, Kevin, 65366, Geisenheim (DE); Umstädter, Timo, 65201, Wiesbaden (DE); Stieglitz, Udo, 65201, Wiesbaden (DE)
(74) Vertreter: WSL Patentanwälte Partnerschaft mbB

(56) Entgegenhaltungen:
- EP-A1- 0 608 698
- DE-A1- 2 816 240
- DE-A1- 2 835 637
- DE-U1- 20 109 663

## Beschreibung

Diese Erfindung betrifft eine Spannungsprüfvorrichtung zum Prüfen einer Spannung zwischen einer leitfähigen Flüssigkeit und einem Standort eines Bedieners der Spannungsprüfvorrichtung.

Beim Einsatz von Rettungsdiensten und Mitarbeitern von Energieversorgungsunternehmen kommt es vor, dass Tätigkeiten an überfluteten Stellen ausgeführt werden müssen. Dies können beispielsweise vollgelaufene Keller, Überschwemmungen oder Stellen sein, an denen viel Wasser austritt, z.B. bei Wasserrohrbrüchen. Dabei besteht die Gefahr, dass das Wasser unter elektrischer Spannung steht. Häufig stammt diese aus dem öffentlichen Niederspannungsnetz. Es sind jedoch auch Fälle bekannt, in denen eine solche Spannung aus Speichern für elektrische Energie, die als Notstrompuffer dienen, oder aus autarken Energieerzeugungssystemen, wie etwa Solaranlagen oder Windkraftanlagen oder dergleichen stammt. Bei den auftretenden Spannungen kann es sich daher um Gleich- oder Wechselspannungen handeln. Bei Unfällen mit flüssigen Chemikalien kann auch eine Überflutung mit einer anderen elektrisch leitfähigen Flüssigkeit als Wasser entstehen.

Für Rettungskräfte und Mitarbeiter von Energieversorgungsunternehmen stellen diese Spannungen ein erhebliches Gefährdungspotential dar, da Wechselspannungen über 50 V und Gleichspannungen über 120 V lebensbedrohlich sind. Die Gefahr besteht darin, dass durch die Spannungen ein Strom durch den menschlichen Körper fließt. Dabei ist u. a. von Bedeutung, an welcher Stelle des Körpers der Strom ein- bzw. austritt. Besonders gefährlich ist das Eintreten durch eine Hand oder einen Arm und das Austreten durch den anderen Arm oder die andere Hand, aber auch das Eintreten durch einen Arm und das Austreten durch ein Bein bzw. umgekehrt. Die Gefahr ist umso größer, je mehr Strom durch das menschliche Herz fließt.

Um dieser Gefahr zu begegnen, ist es notwendig, an überfluteten oder nassen Einsatzorten vor der Kontaktaufnahme mit der Flüssigkeit zu prüfen, ob sie unter Spannung steht. Aus dem Stand der Technik ist eine Vorrichtung bekannt, bei der eine Klemme mit Erdpotential zu verbinden ist. Die Klemme ist über ein Kabel mit einer Handsonde verbunden, die im Betrieb in die Flüssigkeit eingetaucht wird. Der Bediener erhält eine Warnung, wenn das Wasser unter elektrischer Spannung steht. Dieses Gerät hat mehrere Nachteile. Dadurch, dass die Spannung zwischen der Flüssigkeit und einem festen Erdpotential, mit welchem die Klemme verbunden ist, erfasst wird, ist das Prüfergebnis fraglich, denn im allgemeinen liegen keine sicheren Informationen über das Erdpotential vor. Die Handhabung ist dadurch erschwert, dass das Kabel abgewickelt, ein Erdpotential gesucht und daran eine Schraubklemme angebracht werden muss, was unter Umständen schwierig sein kann, und es muss das Kabel der Klemme bis zu der überfluteten Stelle gelegt werden. Diese Arbeiten dürfen an der Einsatzstelle nur von einer Elektrofachkraft ausgeführt werden.

Weiteren Stand der Technik stellen handelsübliche Spannungsprüfgeräte dar, die jedoch nicht speziell für den Einsatz an überfluteten Stellen konzipiert sind. Dazu zählen vor allem Phasenprüfer. Diese sind unter anderem als Phasenprüfer-Schraubendreher mit einer Glimmlampe in einem transparenten Griffstück gebräuchlich, wobei die Glimmlampe aufleuchtet, wenn eine zu prüfende Spannung einen Stromfluss durch den Spannungsprüfer und den Bediener in den Standort des Bedieners verursacht. Diese Phasenprüfer sind im Elektrohandwerk gebräuchlich, um beispielsweise festzustellen, wo auf Leitungen oder in Steckdosen die Phase liegt, was eine Spannungsprüfung gegenüber dem Erdpotential am Standort des Bedieners darstellt. Dies Spannungsprüfgeräte sind nicht für einen rauen Einsatz in einem Notfall konzipiert, und insbesondere auch nicht für die Prüfung von Spannungen in Flüssigkeiten vorgesehen. Außerdem sind die Bediener üblicherweise Elektrofachkräfte, die mit dem Umgang mit gefährlichen elektrischen Spannungen vertraut sind. Aus Gründen des betrieblichen Unfallschutzes dürfen Rettungskräfte und Mitarbeiter von Energieversorgungsunternehmen ohne eine entsprechende Ausbildung als Elektrofachkraft solche Geräte im Dienst nicht benutzen.

Die deutsche Gebrauchsmusterschrift DE 201 09 663 U1 offenbart eine Prüfvorrichtung für elektrische Spannung mit einem von einer Person in einer Hand tragbaren Handgerät, mit einer elektrischen Schaltungsanordnung zum Erzeugen eines Signals bei einem elektrischen Stromfluss in dem Gerät, mit einem elektrisch leitenden Taststab als in das Handgerät einschiebbar ausgebildeten Teleskopstab, der mit der elektrischen Schaltungsanordnung verbunden ist und mit einem elektrisch leitenden Kontakt an der Außenseite des Gerätes, der mit der elektrischen Schaltungsanordnung verbunden ist.

Die EP 0 608 698 A1 offenbart weiterhin ein Prüfgerät zum wahlweisen Anzeigen einer elektrischen Spannung oder des Stromdurchgangs durch einen elektrischen Leiter mit zwei über ein Kabel miteinander verbundenen, jeweils mit einer Prüfspitze versehenen Handgriffen, mit einer Messschaltung sowie mindestens einem Anzeigeelement zur Erfassung und Anzeige des an den Prüfspitzen anliegenden Spannungswertes sowie mit einer Spannungsquelle zur Bereitstellung des für die Messung und Anzeige des Stromdurchgangs erforderlichen Stroms.

Aufgabe der Erfindung gegenüber dem genannten Stand der Technik ist es daher, die genannten Nachteile des Standes der Technik zu überwinden und den Rettungskräften ein Gerät an die Hand zu geben, das von diesen gefahrlos und einfach bedient werden kann.

Erfindungsgemäß wird diese Aufgabe dadurch gelöst, dass eine Spannungsprüfvorrichtung zum Prüfen einer Spannung zwischen einer leitfähigen Flüssigkeit und einem Standort eines Bedieners bereitgestellt wird, mit einer Bedieneranschlussstelle mit mindestens einem leitfähigen Bereich, mit dem die Spannungsprüfvorrichtung im Betrieb mit dem Körper des Bedieners elektrisch verbindbar ist, und einer Flüssigkeitsanschlussstelle mit mindestens einem leitfähigen Bereich, mit dem die Spannungsprüfvorrichtung im Betrieb mit der Flüssigkeit elektrisch verbindbar ist, wobei im Betrieb die zu prüfende Spannung einen Stromfluss durch die Vorrichtung und den Körper des Bedieners verursacht, wobei die zueinander am nächsten liegenden Ränder des elektrisch leitfähigen Bereichs der Bedieneranschlussstelle und des elektrisch leitfähigen Bereichs der Flüssigkeitsanschlussstelle voneinander einen Abstand von mindestens 0,50 m aufweisen.

Durch eine solche Vorrichtung wird es möglich, unabhängig von weiteren Hilfsmitteln, wie etwa einer mit Erdpotential zu verbindenden Klemme, die Spannung auf einer Flüssigkeit zu prüfen. Dabei wird der Stromkreis nicht nur von der leitfähigen Flüssigkeit über die Spannungsprüfvorrichtung zu einem Erdpotential geschlossen und dabei die Spannung geprüft, sondern der Bediener wird zusätzlich selbst Teil des Stromkreises, indem er zwischen der Spannungsprüfvorrichtung und dem Erdpotential für die Prüfung "angeschlossen" wird.

Weiter wird die Sicherheit des Bedieners dadurch erhöht, dass der Abstand von der Stelle, an der der Bediener elektrisch mit der Spannungsprüfvorrichtung verbunden ist, vorzugsweise ist dies seine Hand, und der Stelle, an der die Spannungsprüfvorrichtung mit der Flüssigkeit verbunden ist, mindestens 50 cm beträgt.

An der Bedieneranschlussstelle wird der Bediener mit der Spannungsprüfvorrichtung verbunden. Dazu weist die Bedieneranschlussstelle einen oder mehrere leitfähige Bereiche auf, die der Bediener, vorzugsweise mit seiner Hand, berührt.

Die Bedieneranschlussstelle weist einen leitfähigen Bereich aus einem leitfähigen Material auf, vorzugsweise aus Metall, vorzugsweise aus einem korrosionsfesten Metall, vorzugsweise aus hochlegiertem Edelstahl oder aus Aluminium, alternativ aus Kohlenstofffasern, die vorteilhaft mit einem Harz gebunden sind.

Die Flüssigkeit wird an der Flüssigkeitsanschlussstelle mit der Spannungsprüfvorrichtung verbunden. Die Flüssigkeitsanschlussstelle weist dazu einen oder mehrere leitfähige Bereiche auf.

Die Flüssigkeitsanschlussstelle weist einen leitfähigen Bereich aus einem leitfähigen Material, vorzugsweise aus Metall, vorzugsweise aus einem korrosionsfesten Metall und besonders bevorzugt aus hochlegiertem Edelstahl oder aus Aluminium, alternativ aus Kohlenstofffasern, die vorteilhaft mit einem Harz gebunden sind.

Vorteilhaft wird die Flüssigkeitsanschlussstelle im Betrieb vollständig in die Flüssigkeit eingetaucht. Die Eintauchtiefe kann durch eine Markierung, vorzugsweise in einem Abstand von 10 bis 30 cm von der Flüssigkeitsanschlussstelle, vorgegeben sein. Dadurch kommt die Bedieneranschlussstelle der Oberfläche der Flüssigkeit näher.

Vorzugsweise liegt daher der Abstand zwischen der Flüssigkeitsanschlussstelle und der Bedieneranschlussstelle in einem Bereich von 0,80 m bis 1,50 m, idealerweise beträgt der Abstand 1,20 m.

Der Abstand zwischen der Flüssigkeitsanschlussstelle und der Bedieneranschlussstelle bedeutet im Sinne der vorliegenden Anmeldung die Strecke zwischen der Stelle des Randes oder der Ränder der leitfähigen Bereiche der Flüssigkeitsanschlussstelle bzw. der Bedieneranschlussstelle, die zueinander am nächsten liegen. Berücksichtigt man eine Eintauchtiefe von z. B. 20 cm über die Stelle am Rand des Bereichs oder der Bereiche der Flüssigkeitsanschlussstelle hinaus, die zu der Bedieneranschlussstelle am nächsten liegt, so beträgt der Abstand zwischen der Bedieneranschlussstelle und der Oberfläche der Flüssigkeit vorzugsweise mindestens 1 m. Dies ist als Sicherheitsabstand zu offenliegenden elektrischen Spannungen außer für Elektrofachkräfte in Deutschland gesetzlich vorgeschrieben.

Vorteilhaft ist zwischen die Flüssigkeitsanschlussstelle und die Bedieneranschlussstelle mindestens ein elektrischer Widerstand geschaltet, und die Vorrichtung weist eine Einrichtung zum elektrischen Messen einer Spannung über den Widerstand oder über einen Teil des Widerstands oder eine Einrichtung zum elektrischen Vergleichen dieser Spannung mit einer Schwellspannung auf. Diese Einrichtungen sind vorteilhaft in einen Mikrocontroller integriert.

Wenn aufgrund einer Spannung in der Flüssigkeit ein Strom durch die Spannungsprüfvorrichtung und den Körper des Bedieners fließt, so fällt eine elektrische Spannung über den Widerstand oder über einen Teil des Widerstandes zwischen der Bedieneranschlussstelle und der Flüssigkeitsanschlussstelle ab. Diese Spannung kann herangezogen werden, um das Vorhandensein von elektrischer Spannung in der Flüssigkeit elektrisch zu erfassen. Diese Erfassung kann sowohl in Form einer Messung geschehen, bei der die Spannung über den Widerstand gemessen wird, wobei der Messwert nachfolgend mit einem Schwellwert verglichen wird, oder die Spannung über den Widerstand kann mit einer elektrischen Vergleichseinrichtung unmittelbar mit einer Schwellspannung verglichen werden, deren Überschreiten das Vorhandensein einer bestimmten Spannung in der Flüssigkeit anzeigt, was eine Prüfung darstellt.

Das Ergebnis der Prüfung oder auch das unverarbeitete Messergebnis kann in einer Ausführungsform durch eine entsprechende Anzeigevorrichtung zur Anzeige gebracht werden. Mit dem Messergebnis steht dem Bediener eine sichere Information über die Spannung zur Verfügung, die zwischen der Flüssigkeit und seinem Standort anliegt. Bei einer Messung und Anzeige des Messwertes muss der Bediener jedoch selbst entscheiden, ob die Spannung gefährlich ist.

Der Vergleich mit einer Schwellspannung bietet daher den Vorteil, dass die Schwellspannung so gewählt werden kann, dass sie der Grenze zwischen gefährlicher und ungefährlicher Spannung in der Flüssigkeit entspricht. Bei einer solchen Einstellung erhält der Bediener mit der Anzeige des Überschreitens des Schwellwertes die Information, dass die Spannung gefährlich ist.

Vorteilhaft wird der Gesamtwiderstand zwischen der Flüssigkeitsanschlussstelle und der Bedieneranschlussstelle mindestens so groß gewählt, dass der Strom in die Bedieneranschlussstelle bei einer maximal zu erwartenden Nennspannung zwischen der leitfähigen Flüssigkeit und dem Standort des Bedieners auf 1 mA oder weniger begrenzt ist.

Die Stromstärke von 1 mA durch den menschlichen Körper liegt unterhalb der Wahrnehmungsschwelle für elektrischen Strom. Diese Wahrnehmungsschwelle wiederum liegt weit unterhalb der Grenze für gefährlichen Strom, die für Wechselspannungen bei 30 mA und für Gleichspannungen bei etwa 300 mA liegt. Auf diese Weise ist der Bediener vor gefährlichen Strömen durch seinen Körper gesichert, obwohl er selbst einen Teil des Stromkreises von der Flüssigkeit durch die Spannungsprüfvorrichtung in seinen Standort bildet. Der Bediener spürt den Strom durch seinen Körper nicht, so lange die Spannungsprüfvorrichtung innerhalb ihrer zulässigen Nennspannung betrieben wird. Selbst darüber hinaus kann die Spannung in der Flüssigkeit bei Wechselspannung noch das Dreißigfache der Nennspannung betragen, bei Gleichspannung sogar das Dreihundertfache, bevor lebensgefährlich viel Strom durch den Körper des Bedieners fließt. Dieser wird darüber hinaus durch die Empfindung des Stroms in seinem Körper vor der erhöhten Spannung in der Flüssigkeit gewarnt.

Die Nennspannung der Spannungsprüfvorrichtung ist die Spannung in der Flüssigkeit, die beim bestimmungsgemäßen Betrieb der Spannungsprüfvorrichtung nicht überschritten werden darf. Sie entspricht vorzugsweise der Grenze zwischen dem Nieder- und Hochspannungsbereich, d.h. 1000 V, sodass die in Gebäuden überwiegend vorkommenden effektiven Netzspannungen von 230 V und 400 V erfasst sind. Der Widerstand zwischen der Flüssigkeitsanschlussstelle und der Bedieneranschlussstelle hat in diesem Fall einen Wert von mindestens 1 MΩ. In alternativen Ausführungen kann die Nennspannung auch höher sein, wobei die Widerstände in der Spannungsprüfvorrichtung dann vorteilhaft als hochspannungsfeste Widerstände ausgeführt sind und höhere Widerstandswerte aufweisen.

Vorteilhaft ist der Widerstand in der Spannungsprüfvorrichtung in mindestens zwei einzelne Widerstände aufgeteilt, von denen jeder für sich allein betrachtet eine Größe hat, die den Strom in die Bedieneranschlussstelle bei einer maximal auftretenden Nennspannung zwischen der leitfähigen Flüssigkeit und dem Standort des Bedieners auf die Wahrnehmbarkeitsschwelle von 1 mA oder weniger begrenzt. Dies hat den Vorteil, dass der Strom auf 1 mA oder weniger begrenzt bleibt, selbst wenn einer der Widerstände mit einem Kurzschluss versagt und zu der Strombegrenzung nicht mehr beiträgt. Diese Maßnahme erhöht die Sicherheit für den Bediener weiter. Alternativ kann der Strom nach Versagen eines Widerstands durch Kurzschluss auch auf einen Wert zwischen der Wahrnehmbarkeitsschwelle von 1 mA und der Schwelle zur Lebensgefahr von 30 mA begrenzt sein. Der Bediener wird dann durch die Stromempfindung über das Versagen des Widerstands informiert, ohne dass er durch den erhöhten Strom gefährdet wird.

Vorteilhaft werden hochspannungsfeste Widerstände eingesetzt, die auch dann nicht zerstört werden, wenn die Spannungsprüfvorrichtung erheblich oberhalb der vorgesehenen Nennspannung eingesetzt wird. Die nachfolgenden Verarbeitungsstufen können durch geeignete Schutzbeschaltung, z. B. mit Zenerdioden, vor Beschädigung geschützt werden.

Vorteilhaft kann die Spannungsprüfvorrichtung weiter eine elektronische oder elektromechanische Sicherung enthalten, die den Stromfluss dauerhaft unterbricht, wenn ein bestimmter Strom, z. B. 30 mA, überschritten wird. Die Abschaltgeschwindigkeit ist dabei vorzugsweise so hoch, dass durch den bis zum Abschalten fließenden Strom keine Gefährdung vorliegt.

Vorteilhaft weist die Spannungsprüfvorrichtung einen Analog-Digitalwandler und eine digitale Datenverarbeitungseinrichtung auf, wobei der Analog-Digitalwandler so verschaltet ist, dass er im Betrieb die Spannung über den Widerstand oder über einen Teil des Widerstandes erfasst und digitalisiert und einen oder mehrere Messwerte an die digitale Datenverarbeitungseinrichtung weiterleitet.

Dadurch wird die Spannung in der Flüssigkeit in digitalen Daten verfügbar. Dies bietet die Möglichkeit, die Spannungsprüfvorrichtung auf verschiedene Betriebszustände hin zu kalibrieren, als auch die gemessene Spannung mit einem Schwellwert zu vergleichen, und auf diese Weise im Vergleich zur reinen Messung die Information über die Gefährdung zur Verfügung zu stellen.

Vorteilhaft wird der Spannungsmesswert im Betrieb mit einem Schwellwert verglichen. Durch den Vergleich wird dem Bediener die Information zur Verfügung gestellt, ob eine gefährliche Spannung vorliegt, oder nicht. Der Schwellwert ist vorteilhaft einstellbar. Dadurch kann das Kriterium für den Vergleich an verschiedene Bedingungen angepasst werden, die die Messung beeinflussen. Insbesondere kann der Schwellwert durch eine Kalibrierung eingestellt werden.

Vorteilhaft weist die Spannungsprüfvorrichtung eine oder mehrere Warneinrichtungen auf, die im Betrieb Warnsignale ausgeben, wenn der Spannungsmesswert den Schwellwert in die Richtung überschreitet, die einer höheren Spannung über dem Widerstand oder über einem Teil des Widerstands entspricht.

Durch das eine oder die mehreren Warnsignale erhält der Bediener die Information, dass in der Flüssigkeit eine gefährliche elektrische Spannung anliegt. Das eine oder die mehreren Warnsignale können z. B. jeweils eines oder mehrere akustische Warnsignale , optische Warnsignale, wie etwa das Aufleuchten oder Blinken einer Leuchtdiode, oder auch ein Vibrationsalarm sein. Die Warneinrichtung ist dabei vorzugsweise so eingerichtet, dass der Bediener die Information sicher erhält. Das akustische Signal sollte z. B. laut genug sein, sodass der Bediener es auch bei starker Geräuschentwicklung, was bei einem Notfall nicht ungewöhnlich ist, noch hören kann. Eine optische Anzeige sollte so angeordnet sein, dass sie gut abzulesen ist, während die Flüssigkeitsanschlussstelle in die Flüssigkeit getaucht wird.

Vorteilhaft ist in den Strompfad von der Flüssigkeitsanschlussstelle zu der Bedieneranschlussstelle ein Gleichrichter geschaltet.

Durch den Gleichrichter wird eine Wechselspannung zwischen der Flüssigkeitsanschlussstelle und der Bedieneranschlussstelle gleichgerichtet. Der Gleichrichter kann beispielsweise eine Diode oder ein Brückengleichrichter sein.

In einer Ausführungsform kann der Widerstand, dessen Spannung zur Messung oder zum Spannungsvergleich abgegriffen wird, mit einem Kondensator parallel geschaltet sein, so dass sich aus dieser Anordnung ein einfacher passiver Tiefpass ergibt. Seine Grenzfrequenz ist vorzugsweise so ausgelegt, dass sie deutlich unterhalb der zu erwartenden Frequenz der zu prüfenden Wechselspannungen liegt. Diese Frequenz liegt im europäischen Raum üblicherweise bei 50 Hertz. Durch diesen Tiefpassfilter wird die Halbwellenspannung, die der Gleichrichter erzeugt, in eine Gleichspannung gewandelt. Diese kann dann ohne Synchronisation gemessen oder verglichen werden. Durch diese Anordnung ist es außerdem möglich, Gleichspannungen in der Flüssigkeit zu messen oder zu vergleichen. Der Gleichrichter bleibt dabei ohne wesentliche Funktion, lässt die Gleichspannung jedoch passieren.

Vorzugsweise ist die Spannungsprüfvorrichtung mit einer internen Stromversorgung ausgestattet, die durch eine Batterie oder einen Akkumulator realisiert sein kann. Die vom allgemeinen Stromversorgungsnetz unabhängige Energieversorgung bietet zusammen mit der oben erwähnten Unabhängigkeit von einem Erdpotential uneingeschränkte Mobilität der Spannungsprüfvorrichtung, was in der Praxis einen großen Vorteil darstellt. Akkumulatoren bieten zusätzlich den Vorteil der Wiederverwendbarkeit und stehen bei Verwendung einer Ladestation mit Ladungserhaltungsfunktion stets betriebsbereit zur Verfügung. Alternativ kann eine Spannungsprüfvorrichtung nach der Erfindung auch mit der zu prüfenden Spannung betrieben werden. Wenn die zu prüfende Spannung zu gering oder Null ist, kann beispielsweise das Fehlen von Reaktionen oder der Selbstüberprüfung darauf hinweisen, dass die Spannung unterhalb einer Grenze zu gefährlichen Spannungen liegt.

Vorteilhaft weist die Spannungsprüfvorrichtung eine Funktion zur Selbstüberprüfung auf, mit der zumindest eine Funktion der Spannungsprüfvorrichtung überprüfbar ist.

Da es sich um eine Prüfvorrichtung handelt, die zuverlässig vor Gefahren warnen soll, ist ein Versagen der Prüfvorrichtung selbst mit einem hohen Gefährdungspotential verbunden. Die Gefahr ist dadurch noch erhöht, dass der Bediener selbst Teil des Stromkreises ist, durch den die zu prüfende gefährliche Spannung einen Stromfluss verursacht. Ein Versagen des Gerätes dahingehend, dass dieser Strom zu groß wird, gefährdet den Bediener unter Umständen schon bei der Prüfung.

Gegenstand der Selbstüberprüfung können daher beispielsweise folgende Funktionen sein: Messung des Widerstandes zwischen Messspitze und Griff und gegebenenfalls Feststellung eines Defekts, bevor die Messung durchgeführt wird, Batterietest, Selbsttest des Mikrocontrollers und Tests sämtlicher Anzeige- und Warneinrichtungen. Eine Widerstandsmessung kann z. B. ausgeführt werden, indem eine bekannte Spannung an die Messspitze und den Griff angelegt wird, z. B. eine aus der Batteriespannung erzeugte konstante Spannung, und die dadurch erzeugte Spannung an dem Widerstand, über den gemessen wird, zur Selbstkontrolle mit einem speziell dafür eingerichteten Schwellwert oder einer Schwellspannung verglichen wird. Ein Überschreiten dieser Schwelle zeigt, an, dass der Widerstand zwischen der Bedieneranschlussstelle und der Flüssigkeitsanschlussstelle zu gering ist. Die Batteriespannung kann ebenfalls gemessen und mit einem speziellen Schwellwert verglichen werden, beispielsweise digital innerhalb einer digitalen Datenverarbeitungseinrichtung, oder sie kann direkt mit einer speziell dafür vorgesehenen Schwellspannung verglichen werden. Das Messergebnis kann z. B. über eine Leuchtdiode oder eine andere Warneinrichtung angezeigt werden.

Die Warneinrichtungen selbst können nach dem Einschalten oder nach dem Auslösen einer Selbstüberprüfung für eine begrenzte Zeit in Betrieb genommen werden. Im Testbetrieb kann die Art der Anzeige von der Art der Anzeige im Betrieb verschieden sein, z. B. kann beim Test eine Blinkfunktion, beispielsweise auch mit einer besonderen Frequenz, verwendet werden, während im Betrieb ein dauerndes Leuchten oder eine Blinkfrequenz für den Betrieb zum Einsatz kommt. Bei akustischen Warneinrichtungen kann entsprechend eine Abfolge von Warntönen im Gegensatz zu einer anderen Abfolge oder einem zeitlich begrenzten Dauerton im Betrieb eingesetzt werden. Zusätzlich kann die Frequenz der Warntöne gegenüber dem Betrieb verändert sein, oder es können bestimmte Abfolgen von verschiedenen Tönen verwendet werden.

Vorteilhaft weist die Spannungsprüfvorrichtung eine Anzeigeeinrichtung für den Ladezustand der Batterie auf, die das Gerät im Betrieb mit Strom versorgt.

Dadurch wird zusätzlich zu einer eventuell vorhandenen Selbstüberprüfung dem Bediener während des Betriebs angezeigt, ob die Stromversorgung des Gerätes sichergestellt ist. Ein anstehender Batteriewechsel kann durch einen bestimmten Zustand oder Zustandsübergang der Anzeige signalisiert werden und wird dadurch mit ausreichender Vorlaufzeit erkennbar.

Die der Erfindung zugrundeliegende Aufgabe wird auch durch ein Verfahren zum Prüfen der Spannung zwischen einer leitfähigen Flüssigkeit und dem Standort eines Bedieners gelöst, bei dem bei der Prüfung eine Flüssigkeitsanschlussstelle mit mindestens einem leitfähigen Bereich mit der zu prüfenden Flüssigkeit und eine Bedieneranschlussstelle mindestens einem leitfähigen Bereich mit dem Bediener, insbesondere mit seiner Hand, elektrisch verbunden wird, nach dem Verbinden ein Strom durch eine elektrische Verbindung zwischen der Flüssigkeitsanschlussstelle und der Bedieneranschlussstelle und durch den Körper des Bedieners fließt, wobei der Abstand der zueinander am nächsten liegenden Ränder des leitfähigen Bereichs der Flüssigkeitsanschlussstelle und des leitfähigen Bereichs der Bedieneranschlussstelle mindestens 0,50 m beträgt.

Dadurch, dass die Flüssigkeitsanschlussstelle und die Bedieneranschlussstelle einen Abstand von mehr als 0,5 m aufweisen, vorzugsweise einen Abstand in einem Bereich von 0,8 m bis 1,5 m, idealerweise einen Abstand von 1,2 m, wird sichergestellt, dass sich der Bediener im Betrieb in ausreichendem Abstand von der potentiell gefährlichen Flüssigkeit befindet. Dadurch, dass die zu prüfende Spannung einen Stromfluss durch den Körper des Bedieners in seinen Standort erzeugt, benötigt das Verfahren nicht das Ableiten von Strom in ein Erdpotential, das gesondert angeschlossen werden müsste. Das Prüfverfahren ist deshalb autark.

Vorteilhaft wird bei dem Verfahren die elektrische Spannung über den Widerstand oder einen Teil des Widerstands zwischen der Flüssigkeitsanschlussstelle und der Bedieneranschlussstelle elektrisch gemessen und der gemessene Wert mit einem Schwellwert verglichen, oder diese Spannung durch eine elektronische Schaltung mit einer Schwellspannung verglichen.

Dieser Verfahrensschritt gewinnt die Informationen über die Höhe der Spannung in der Flüssigkeit oder direkt eine Information über die Gefährlichkeit der Spannung in der Flüssigkeit, wenn die Schwellspannung so festgelegt ist, dass die Schwelle der Grenze zur Gefährdung entspricht. Das Ergebnis des Vergleichs kann dann direkt als Warnung vor einer gefährlichen Spannung ausgegeben werden. Der Messwert kann z. B. in einer Datenverarbeitungseinrichtung weiterverarbeitet werden, und von dieser mit einem Schwellwert verglichen werden, wobei dieser Schwellwert der Grenze zur Gefährdung entspricht, und das Ergebnis dieses Vergleichs mit einer Warneinrichtung ausgegeben werden kann.

Weiter kann das Verfahren den Schritt enthalten, dass die Schwellspannung oder der Schwellwert in einem Kalibriervorgang festgelegt werden, bei dem ein bekanntes Potential an die Flüssigkeitsanschlussstelle angelegt wird, die Spannung über den Widerstand oder über einen Teil des Widerstandes gemessen wird, daraus der Schwellwert oder die Schwellspannung abgeleitet wird, und der Schwellwert oder Schwellspannung für den Vergleich mit einem Messwert oder mit einer Spannung gespeichert wird.

Dadurch kann die Grenze zur Gefährdung auf die tatsächlichen Betriebsbedingungen der Spannungsprüfvorrichtung eingestellt werden. Die Betriebsbedingungen können z. B. durch variierende Isolierung des Bedieners gegenüber seinem Standort schwanken. Dies kann z. B. durch die Verwendung unterschiedlicher Kleidungsstücke oder Schuhe der Fall sein. Außerdem kann der Widerstand zwischen der Spannungsprüfvorrichtung und dem Körper von Bedienern, insbesondere ihrer Hände, unterschiedlich sein, z. B. durch verschiedene Feuchtigkeiten oder Dicken der Haut. Die Kalibrierung kann daher vorteilhaft auf eine Person und ihre Bekleidung einschließlich ihrer Schuhe abgestimmt werden. Vorteilhaft können in einer Datenverarbeitungseinrichtung in dem Messgerät verschiedene Schwellwerte gespeichert sein, die bestimmten Personen und/oder Zuständen dieser Personen und/oder Bekleidungen dieser Personen entsprechen. Vorteilhaft können diese Schwellwerte beim Betrieb aus einem Speicher mit Hilfe von Bedien- und Anzeigeeinrichtungen abgerufen werden und für die nächste oder die nächsten Prüfungen oder Messungen zum Einsatz kommen.

Neben der Anpassung der Mess- oder Prüfbedingungen, die mit dem Bediener zusammenhängen, kann der Kalibrierschritt auch Veränderungen in der Spannungsprüfvorrichtung selbst korrigieren. Dies können z. B. Veränderungen des Widerstands zwischen der Flüssigkeitsanschlussstelle und der Bedieneranschlussstelle oder Veränderungen von Referenzspannungen für die Messung oder die Erzeugung der Schwellspannung sein.

Der Schwellwert, der das Ergebnis der Kalibrierung darstellt, kann auf folgende Weise gewonnen werden. Es kann als bekanntes Potential bei der Kalibrierung die Grenzspannung zur Gefährdung an eine Flüssigkeit angelegt werden, die für die Kalibrierung zum Einsatz kommt. Der gemessene Wert entspricht dann dem Schwellwert, der wiederum der Grenze zur Gefährdung entspricht. Alternativ kann auch ein anderes Potential an die Flüssigkeit angelegt werden. Zur Gewinnung des Schwellwertes, der dem Übergang zur Gefährdung entspricht, muss der gemessene Wert mit einem Wert multipliziert werden, der sich aus der Grenzspannung zur Gefährdung geteilt durch das angelegte bekannte Potential berechnet.

In einer Ausführungsform mit einem elektrischen Vergleich der Spannung über dem Widerstand mit einer Schwellspannung kann die Schwellspannung beim Kalibriervorgang beispielsweise mit einem Potentiometer manuell eingestellt werden. Die Größe der einzustellenden Schwellspannung kann analog zu der im vorangehenden Absatz beschriebenen Ermittlung des Schwellwertes festgelegt werden.
Weitere Vorteile, Merkmale und Anwendungsmöglichkeiten der Erfindung ergeben sich aus der folgenden Beschreibung bevorzugter Ausführungsformen als auch aus den dazugehörigen Figuren. Es zeigen:
- Figur 1: eine schematische Darstellung einer Ausführungsform der Spannungsprüfvorrichtung gemäß der Erfindung, und
- Figur 2: einen elektrischen Schaltplan einer Ausführungsform der Spannungsprüfvorrichtung gemäß der Erfindung.

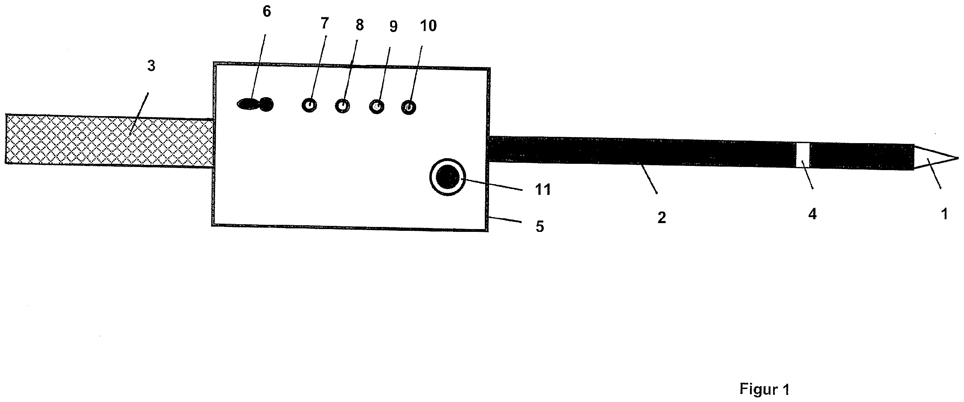

In Figur 1 ist eine Ausführungsform der erfindungsgemäßen Spannungsprüfvorrichtung nach der Erfindung gezeigt.

Die Vorrichtung besteht aus einer Bedieneranschlussstelle 3, einem Verbindungsstück 2 und der Flüssigkeitsanschlussstelle 1, als Spitze des Verbindungsstücks 2. Zwischen der Bedieneranschlussstelle 3 und der Flüssigkeitsanschlussstelle 1 befindet sich eine Bedien- und Anzeigeeinheit 5, in der der Hauptschalter 6, die optischen Anzeigeelemente 7 bis 10 und der Lautsprecher oder Summer angeordnet sind. Die Bedien- und Anzeigeeinheit 5 nimmt sowohl die Messelektronik, als auch die Batterie auf, die zur Versorgung der Messelektronik erforderlich ist. Die Bedieneranschlussstelle 3 ist mit dem Verbindungsstück 2 verbunden, und die Bedien- und Anzeigeeinheit 5 ist mit dem Verbindungsstück 2 verbunden.

In einer alternativen, nicht dargestellten Ausführungsform ist die Bedien- und Anzeigeeinheit 5 mit dem Griffstück 3 verbunden. In einer weiteren alternativen Ausführungsform ist die Bedieneranschlussstelle 3 mit der Bedien- und Anzeigeeinheit 5 verbunden, wobei auch das Verbindungsstück 2 mit der Bedien- und Anzeigeeinheit 5 mechanisch verbunden ist.

Die mechanische Stabilität der Komponenten und der Verbindung ist so groß gewählt, dass die Spannungsprüfvorrichtung nicht wesentlich durchhängt, wenn sie an der Bedieneranschlussstelle 3 waagerecht gehalten wird.

Die Bedieneranschlussstelle 3 besteht aus hochlegiertem Edelstahl. Die Bedieneranschlussstelle ist dabei zylindrisch ausgeführt. Um den Übergangswiderstand zur Haut zu verringern, ist die Oberfläche der Bedieneranschlussstelle 3 der Vorrichtung aus Figur 1 aufgeraut, in einer alternativen Ausführungsform gerändelt. Die Länge der Bedieneranschlussstelle 3 in axialer Richtung entspricht mindestens etwa der Handbreite des Bedieners. Der Durchmesser der Bedieneranschlussstelle 3 beträgt 35 mm. Durch diese Abmessungen wird ein guter elektrischer Kontakt und ein sicherer Halt der Bedieneranschlussstelle 3 in der Hand des Bedieners gewährleistet.

Das Verbindungsstück 2 besteht aus einem elektrisch schlecht leitenden Isoliermaterial, wodurch die Isolierung der Flüssigkeitsanschlussstelle 1 von der Bedieneranschlussstelle 3 realisiert ist. Als Material wird ein Kunststoff verwendet. In einer alternativen Ausführungsform kann alternativ auch ein außen beschichtetes Metallrohr verwendet werden. In dieser alternativen Ausführungsform kann das Signal von der Flüssigkeitsanschlussstelle 1 durch das Metall des Verbindungsstücks 2 zu der Bedien- und Anzeigeeinheit geleitet werden.

In der Ausführungsform in Figur 1 ist im Inneren des Verbindungsstücks 2 ein Kabel verlegt, mit dem das Signal von der Flüssigkeitsanschlussstelle 1 zu der Bedien- und Auswerteeinheit 5 geleitet wird. Außen auf dem Verbindungsstück 2 ist eine Markierung 4 angebracht, die dem Bediener anzeigt, wie tief er die Flüssigkeitsanschlussstelle in die zu prüfende Flüssigkeit eintauchen soll. Dies beugt falschen Prüfbedingungen durch zu geringe Eintauchtiefe vor, wie auch zu tiefem Eintauchen, wodurch der Sicherheitsabstand zwischen der Bedieneranschlussstelle und der Wasseroberfläche unterschritten werden kann. Die Markierung 4 ist in einem Sicherheitsabstand von 1 m von dem der Markierung zugewandten Rand der Bedieneranschlussstelle angeordnet. Das Verbindungsstück 2 ist vorzugsweise als dünnwandiges Rohr mit rundem Querschnitt ausgeführt. Dadurch wird ein geringes Gewicht bei gleichzeitig wenig Durchbiegung bzw. Durchhang realisiert.

Die Flüssigkeitsanschlussstelle 1 ist spitz ausgeführt, so dass sie alternativ zum Prüfen einer reinen Flüssigkeit auch leicht in feuchten Boden oder in Schlamm gesteckt werden kann. Außerdem bewirkt die spitze Form psychologisch, dass die Spitze als vom Bediener entfernt zu verwendende Seite und damit als Prüfspitze oder Messstelle wahrgenommen wird. Die Flüssigkeitsanschlussstelle 1 ist aus hochlegiertem Edelstahl hergestellt. In einer alternativen, nicht dargestellten Ausführung kann auf ein weniger korrosionsfestes Material eine korrosionsfeste, leitfähige Beschichtung aufgebracht sein, z. B. eine Gold- oder Chromschicht.

Die Bedien- und Anzeigeeinheit 5 ist aus schlagfestem Kunststoff hergestellt. Dadurch hat die Spannungsprüfvorrichtung im rauen Rettungseinsatz eine längere Lebensdauer. Auf bzw. in der Oberfläche der Bedien- und Anzeigeeinheit sind vier Leuchtdioden 7, 8, 9 und 10 angeordnet, die folgende Zustände anzeigen:

| | |
|---|---|
| Leuchtdiode 7 | Batterie in Ordnung |
| Leuchtdiode 8 | Batterie ersetzen |
| Leuchtdiode 9 | keine Gefahr |
| Leuchtdiode 10 | Gefahr |

Vorzugsweise ist Leuchtdiode 7 grün, Leuchtdiode 8 rot, Leuchtdiode 9 grün und Leuchtdiode 10 rot ausgeführt. Zusätzlich kann eine weitere Leuchtdiode vorgesehen sein (nicht dargestellt), die eine schwache Batterie anzeigt und in gelb ausgeführt ist.

Die Anzeigeelemente und Bedienelemente sind versenkt angeordnet, so dass sie im rauen Einsatz besser vor Stößen und Schlägen geschützt sind. Das Gehäuse ist vorzugsweise mit der Schutzart IP65, IP66 oder IP67 ausgeführt. Der elektrische Anschluss der Bedieneranschlussstelle kann entweder über ein Kabel oder durch Anordnung der Bedieneranschlussstelle 3 direkt neben der Platine in der Bedien- und Anzeigeeinrichtung 5 durch eine sehr kurze Verbindungsleitung oder durch direkten Anschluss realisiert sein. Ebenso ist ein metallisches Rohr, das das Verbindungsstück 2 darstellt, mit einer sehr kurzen Verbindungsleitung oder direkt an die Platine in der Bedien- und Anzeigeeinrichtung 5 angeschlossen.

Die Bedieneranschlussstelle 3 und das Verbindungsstück 2, wenn es aus leitfähigem Material besteht, müssen an den Enden, die einander zugewandt sind, einen Abstand haben, so dass sich kein Kurzschluss zwischen der Bedieneranschlussstelle 3 und der Flüssigkeitsanschlussstelle 1 bildet.

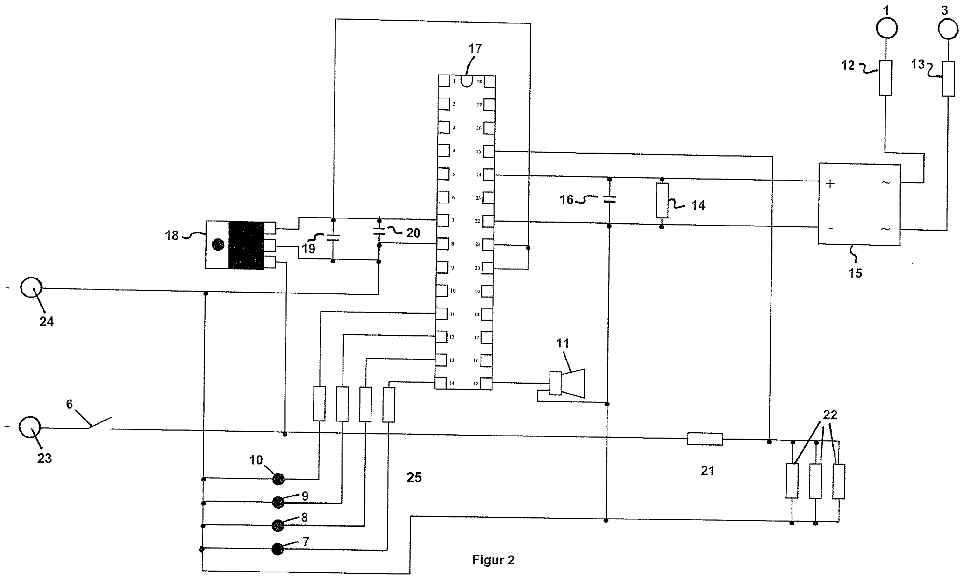

In Figur 2 ist ein elektrischer Schaltplan einer Ausführungsform der Spannungsprüfvorrichtung gemäß der Erfindung gezeigt. Die Platine, auf der die Schaltung realisiert ist, ist in der Bedingungs- und Anzeigeeinrichtung 5 untergebracht.

In Figur 2 sind die Anschlüsse für die Flüssigkeitsanschlussstelle 1 und die Bedieneranschlussstelle 3 dargestellt. Wenn eine Spannung an der Flüssigkeitsanschlussstelle 1 vorhanden ist, verursacht diese einen Strom durch einen ersten Strombegrenzungswiderstand 12 durch einen Brückengleichrichter 15, über einen zweiten Strombegrenzungswiderstand 14, ein zweites Mal durch den Brückengleichrichter 15 und schließlich durch einen dritten Strombegrenzungswiderstand 13 zur Bedieneranschlussstelle 3, von der es in den Bediener abfließt. Die Strombegrenzungswiderstände 12 und 13 haben Werte von je 500 kΩ, und der Strombegrenzungswiderstand 14 hat einen Wert von 56 kΩ. Der Strombegrenzungswiderstand 14 dient gleichzeitig als Shunt für die Strommessung. Dem Strombegrenzungswiderstand 14 ist ein Kondensator 16 parallel geschaltet, der die Halbwellenspannung, die bei Anliegen von Wechselspannung aus dem Brückengleichrichter 15 austritt, glättet und dadurch eine Gleichspannung für die Messung zur Verfügung stellt. In eine digitale Datenverarbeitungseinrichtung 17 ist ein Analog-Digital-Wandler integriert. Die digitale Datenverarbeitungseinrichtung 17 ist ein Mikrocontroller vom Typ Atmel ATmega8. In anderen Ausführungsformen werden andere Mikrocontroller oder DSPs eingesetzt. Die Anschlüsse des Analog-Digital-Wandlers, die aus der digitalen Datenverarbeitungseinrichtung 17 herausgeführt sind, sind mit den Anschlüssen des Kondensators 16, bzw. des Widerstands 14 und den Ausgangsanschlüssen des Brückengleichrichters 15 verbunden. Der digitalen Datenverarbeitungseinrichtung 17 steht dadurch die Spannung über den Strombegrenzungswiderstand 14 zur Verfügung. In der digitalen Datenverarbeitungseinrichtung 17 ist ein Computerprogramm implementiert, das das Messverfahren nach der Erfindung realisiert. Das Programm führt insbesondere den Vergleich der gemessenen Spannung über den Strombegrenzungswiderstand 14 mit einem internen Schwellwert durch, dessen Ergebnis die Information ist, ob an der Flüssigkeitsanschlussstelle 1 eine gefährliche Spannung anliegt oder nicht. Das Messergebnis wird über die Leuchtdiode 10, die über einen Vorwiderstand 25 am Anschluss 11 der Datenverarbeitungseinrichtung angeschlossen ist, ausgegeben, wenn eine Gefahr vorliegt; alternativ wird über die Leuchtdiode 9, die über einen weiteren Vorwiderstand 25 an den Anschluss 12 der Datenverarbeitungseinrichtung 17 angeschlossen ist, die Information ausgegeben, dass die Spannung an der Flüssigkeitsanschlussstelle ungefährlich ist. Dadurch wird immer ein Zustand angezeigt, was zu einer guten Betriebssicherheit beiträgt. Zusätzlich wird über den Anschluss 15, der mit einem Lautsprecher 11 oder in einer alternativen Ausführungsform mit einem Summer 11 verbunden ist, ein Warnton ausgegeben, wenn die Spannung an der Flüssigkeitsanschlussstelle 1 gefährlich ist.

In Figur 2 sind die Anschlüsse 23 und 24 für die Batterie gezeigt, die die Schaltung mit Betriebsstrom versorgt. Die Betriebsstromversorgung kann über den Ein-/Aus-Schalter 6 ein- und ausgeschaltet werden. Die digitale Datenverarbeitungseinrichtung 17 wird nicht direkt mit der Batteriespannung versorgt, sondern mit der Spannung, die ein Festspannungsregler 18 aus der Batteriespannung erzeugt. Dies hat den Vorteil, dass die digitale Datenverarbeitungseinrichtung 17 statt der Batteriespannung, die über die Lebensdauer der Batterie absinkt, eine konstante Spannung erhält. Dies ist insbesondere wichtig, weil diese Spannung in der vorliegenden Ausführung auch als Referenzspannung für die Messungen mit dem integrierten Analog-Digital-Wandler verwendet wird. Die Spannung wird am Ausgang des Festspannungsreglers 18 durch die Kondensatoren 19 und 20 stabilisiert und geglättet.

Eine der Sicherheitsfunktionen der Spannungsprüfvorrichtung ist eine Batterieselbstkontrolle. Dafür wird die Batteriespannung über einen Spannungsteiler aus den Widerständen 21 und 22 auf einen zweiten Analog-Digital-Wandler der Datenverarbeitungseinrichtung 17 gelegt. Dadurch steht der Datenverarbeitungseinrichtung 17 die Information über den Batteriezustand zur Verfügung. Die Datenverarbeitungseinrichtung 17 ist so programmiert, dass sie über ihren Anschluss 14 und einen Vorwiderstand 25 die Leuchtdiode 7 ("Batterie in Ordnung") einschaltet, wenn der gemessene Wert, der der Batteriespannung entspricht, oberhalb eines ersten Batteriespannungsschwellwertes liegt. Der erste Batteriespannungsschwellwert ist in dem Programm fest vorgegeben. Wenn die gemessene Spannung den ersten Batteriespannungsschwellwert unterschreitet und gleichzeitig einen zweiten, kleineren Batteriespannungsschwellwert überschreitet, so veranlasst das Programm, dass über einen Anschluss 13 der Datenverarbeitungseinrichtung 17 über einen weiteren Vorwiderstand 25 die Leuchtdiode 8 ("Batterie ersetzen") eingeschaltet wird. Der zweite Batteriespannungsschwellwert ist ebenfalls fest in dem Programm gespeichert. Zusätzlich kann eine weitere Leuchtdiode vorgesehen sein (im Bild nicht gezeigt), die über einen weiteren Anschluss der Datenverarbeitungseinrichtung 17 und einen weiteren Vorwiderstand 25 eingeschaltet wird, wenn auch der zweite Batteriespannungsschwellwert unterschritten wird.

Die Datenverarbeitungseinrichtung 17 ist so programmiert, dass sie nach dem Einschalten der Betriebsstromversorgung über den Schalter 6 eine Selbstüberprüfung durchführt. Dabei werden nacheinander oder gleichzeitig alle Anzeigeeinrichtungen, d.h. die Leuchtdioden und der Lautsprecher bzw. Summer, eine begrenzte Zeit betätigt. Der Bediener kann dadurch feststellen, ob alle Anzeigeeinrichtungen und die Datenverarbeitungseinrichtung ordnungsgemäß arbeiten. Außerdem wird in einer alternativen Ausführungsform ein weiterer Überprüfungsschritt durchgeführt, mit dem die Strombegrenzungswiderstände 12, 13 und 14 sowie der Gleichrichter 15 geprüft werden können. Für diese Prüfung wird von der Datenverarbeitungseinrichtung 17 ein bekanntes Potential an die Flüssigkeitsanschlussstelle 1 angelegt und ein zweites bekanntes Potential an die Bedieneranschlussstelle 3 angelegt. Die dazu erforderlichen Verbindungen und Schalteinrichtungen, die das Anlegen und Trennen der Potentiale ermöglichen, sind in der Figur 2 nicht dargestellt. Durch das Anlegen der bekannten Potentiale muss über dem Spannungsbegrenzungswiderstand 14 eine bekannte Spannung messbar sein, wenn die Widerstände 12, 13 und 14 sowie der Gleichrichter 15 einen ordnungsgemäßem Zustand aufweisen. Falls dies nicht der Fall ist, kann das Programm die Datenverarbeitungseinrichtung 17 veranlassen, eine Warnung auszugeben.

In einer alternativen Ausführung kann auch signalisiert werden, dass die Strombegrenzungswiderstände 12, 13 und 14 sowie der Gleichrichter 15 ordnungsgemäß arbeiten. Es kann eine zusätzliche Leuchtdiode vorgesehen sein (im Bild nicht gezeigt), die über einen weiteren Anschluss der Datenverarbeitungseinrichtung 17 und einen weiteren Vorwiderstand 25 eingeschaltet wird, wenn die beschriebene Prüfung ein negatives Ergebnis hat.

Um eine Kalibrierung durchzuführen, wird die Flüssigkeitsanschlussstelle 1 mit einem bekannten, außerhalb der Spannungsprüfvorrichtung angeordneten Potential in Verbindung gebracht. Die Bedieneranschlussstelle wird mit dem Körper des Bedieners in Verbindung gebracht. Dadurch stellt sich an dem Strombegrenzungswiderstand 14 eine Spannung ein. Diese wird von der Datenverarbeitungseinrichtung 17 gemessen. Aus diesem Messwert wird ein Schwellwert abgeleitet, der bei späteren Messungen im Betrieb für den Vergleich herangezogen wird, der über die Gefährlichkeit der Spannung an der Flüssigkeitsanschlussstelle entscheidet. Wenn an der Flüssigkeitsanschlussstelle eine Spannung angelegt wurde, die der Grenze zwischen Gefährlichkeit und Ungefährlichkeit entspricht, so kann der gemessene Wert direkt als Schwellwert verwendet werden. Wenn eine andere Spannung angelegt wurde, so kann der Wert als Schwellwert verwendet werden, der sich durch die Multiplikation des gemessenen Wertes mit einem Wert ergibt, der sich aus der Grenzspannung zwischen Gefährlichkeit und Ungefährlichkeit geteilt durch die angelegte Spannung berechnet. Dieser Wert kann in der Datenverarbeitungseinrichtung berechnet werden, wobei in dem Programm der Datenverarbeitungseinrichtung die Größe der angelegten Spannung bekannt sein muss. Alternativ kann der Messwert über eine Schnittstelle mit einer weiteren Datenverarbeitungseinrichtung (nicht dargestellt), beispielsweise mit einem PC, aus der Datenverarbeitungseinrichtung 17 ausgelesen werden, an der weiteren Datenverarbeitungseinrichtung 17 der Schwellwert berechnet werden, und über eine Schnittstelle an die Datenverarbeitungseinrichtung 17 zurück übertragen werden. Diese speichert den Schwellwert vorübergehend oder dauerhaft. Es ist auch möglich, mehrere verschiedene Schwellwerte in der Datenverarbeitungseinrichtung 17 zu speichern. Wenn diese verschiedenen Bedienern oder verschiedenen Bekleidungen oder verschiedenen Betriebsbedingungen zugeordnet sind, kann der jeweilige Bediener in Abhängigkeit der vorgefundenen Bedingungen einen geeigneten Schwellwert aktivieren, ohne dass unmittelbar eine Kalibrierung durchgeführt werden muss. Dazu kann die Datenverarbeitungseinrichtung 17 mit einer Auswahleinrichtung verbunden sein, mit der der Bediener die entsprechende Kalibrierung auswählen kann (in der Figur 2 nicht gezeigt). Zusätzlich kann außerdem eine weitere Anzeigeeinrichtung mit der Datenverarbeitungseinrichtung 17 verbunden werden, die Informationen über verfügbare Schwellwerte und den aktivierten Schwellwert bereitstellt (in der Figur nicht gezeigt).

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln, als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und Lesbarkeit wegen verzichtet.

## Patentansprüche

1. Spannungsprüfvorrichtung zum Prüfen einer Spannung zwischen einer leitfähigen Flüssigkeit und einem Standort eines Bedieners mit
einer Bedieneranschlussstelle (3) mit mindestens einem leitfähigen Bereich, mit dem die Spannungsprüfvorrichtung im Betrieb mit dem Körper des Bedieners elektrisch verbindbar ist, vorzugsweise mit seiner Hand, und
einer Flüssigkeitsanschlussstelle (1) mit mindestens einem leitfähigen Bereich, mit dem die Spannungsprüfvorrichtung im Betrieb mit der Flüssigkeit elektrisch verbindbar ist,
wobei im Betrieb die zu prüfende Spannung einen Stromfluss durch die Vorrichtung und den Körper des Bedieners verursacht,
**dadurch gekennzeichnet, dass** die zueinander am nächsten liegenden Ränder des elektrisch leitfähigen Bereichs der Bedieneranschlussstelle (3) und des elektrisch leitfähigen Bereichs der Flüssigkeitsanschlussstelle (1) voneinander einen Abstand von mindestens 0,50 m aufweisen.

2. Spannungsprüfvorrichtung nach Anspruch 1,
**dadurch gekennzeichnet, dass** zwischen die Flüssigkeitsanschlussstelle (1) und die Bedieneranschlussstelle (3) mindestens ein elektrischer Widerstand (12, 13, 14) geschaltet ist, und die Vorrichtung eine Einrichtung zum elektrischen Messen einer Spannung über den Widerstand (12, 13, 14) oder über einen Teil des Widerstandes (14) oder eine Einrichtung zum elektrischen Vergleichen dieser Spannung mit einer Schwellspannung aufweist.

3. Spannungsprüfvorrichtung nach Anspruch 2 oder 3,
**dadurch gekennzeichnet, dass** der elektrische Widerstand (12, 13, 14) zwischen der Flüssigkeitsanschlussstelle (1) und der Bedieneranschlussstelle (3) mindestens so groß gewählt ist, dass der Strom in die Bedieneranschlussstelle (3) bei einer maximal auftretenden Nennspannung zwischen der leitfähigen Flüssigkeit und dem Standort des Bedieners auf 1 mA oder weniger begrenzt ist.

4. Spannungsprüfvorrichtung nach Anspruch 3, **dadurch gekennzeichnet, dass** der elektrische Widerstand (12, 13, 14) in mindestens zwei einzelne Widerstände (12, 13, 14) aufgeteilt ist, von denen jeder eine Größe hat, die den Strom in die Bedieneranschlussstelle (3) bei einer maximal auftretenden Nennspannung zwischen der leitfähigen Flüssigkeit und dem Standort des Bedieners auf 1 mA oder weniger begrenzt.

5. Spannungsprüfvorrichtung nach Anspruch 3 oder 4,
**dadurch gekennzeichnet, dass** sie einen Analog-Digitalwandler und eine digitale Auswerteeinrichtung (17) aufweist,
wobei der Analog-Digitalwandler so verschaltet ist, dass die Spannung über den Widerstand (12, 13, 14) oder über einen Teil des Widerstandes im Betrieb erfassbar und digitalisierbar ist und der digitalen Auswerteeinrichtung ein oder mehrere Messwerte zur Verfügung stehen.

6. Spannungsprüfvorrichtung nach Anspruch 5,
**dadurch gekennzeichnet, dass** die Auswerteeinrichtung so eingerichtet ist, dass im Betrieb ein Vergleich zwischen dem Spannungsmesswert und einem Schwellwert stattfindet.

7. Spannungsprüfvorrichtung nach Anspruch 6,
**dadurch gekennzeichnet, dass** der Schwellwert einstellbar ist.

8. Spannungsprüfvorrichtung nach einem der Ansprüche 6 oder 7,
**dadurch gekennzeichnet, dass** die Spannungsprüfvorrichtung eine Warneinrichtung (10, 11) aufweist, die im Betrieb ein Warnsignal ausgibt, wenn der Spannungsmesswert den Schwellwert in die Richtung überschreitet, die einer höheren Spannung über den Widerstand (12, 13, 14) oder über einen Teil des Widerstandes (14) entspricht.

9. Spannungsprüfvorrichtung nach einem der Ansprüche 3 bis 8,
**dadurch gekennzeichnet, dass** in den Strompfad von der Flüssigkeitsanschlussstelle (1) zu der Bedieneranschlussstelle (3) ein Gleichrichter (15) geschaltet ist.

10. Spannungsprüfvorrichtung nach Anspruch 1,
**dadurch gekennzeichnet, dass** sie eine Funktion zur Selbstüberprüfung aufweist, mit der zumindest eine Funktion der Spannungsprüfvorrichtung überprüfbar ist.

11. Spannungsprüfvorrichtung nach einem der vorangehenden Ansprüche,
**dadurch gekennzeichnet, dass** sie eine Anzeigeeinrichtung (7, 8) für einen Ladezustand einer Batterie aufweist.

12. Verfahren zum Prüfen einer Spannung zwischen einer leitfähigen Flüssigkeit und einem Standort eines Bedieners,
bei dem bei der Prüfung eine Flüssigkeitsanschlussstelle (1) mit mindestens einem leitfähigen Bereich mit der zu prüfenden Flüssigkeit und eine Bedieneranschlussstelle (3) mit mindestens einem leitfähigen Bereich mit dem Bediener, insbesondere mit seiner Hand, elektrisch verbunden wird,
nach dem Verbinden ein Strom durch eine elektrische Verbindung (12, 13, 14) zwischen der Flüssigkeitsanschlussstelle (1) und der Bedieneranschlussstelle (3) und durch den Körper des Bedieners fließt,
**dadurch gekennzeichnet, dass** der Abstand der zueinander am nächsten liegenden Ränder des leitfähigen Bereichs der Flüssigkeitsanschlussstelle (1) und des leitfähigen Bereichs der Bedieneranschlussstelle (3) mindestens 0,50 m beträgt.

13. Verfahren nach Anspruch 12, **dadurch gekennzeichnet, dass** die elektrische Spannung über den Widerstand (12, 13, 14) oder über einen Teil des Widerstandes (14) elektrisch gemessen wird und der gemessene Wert mit einem Schwellwert verglichen wird, oder diese Spannung durch eine elektronische Schaltung mit einer Schwellspannung verglichen wird.

14. Verfahren nach Anspruch 12 oder 13, **dadurch gekennzeichnet,**
**dass** der Schwellwert oder die Schwellspannung in einem Kalibriervorgang festgelegt wird, bei dem Kalibriervorgang ein bekanntes Potential an die Flüssigkeitsanschlussstelle (1) angelegt wird,
die Spannung über den Widerstand (12, 13, 14) oder über einen Teil des Widerstandes (14) gemessen wird,
daraus der Schwellwert oder die Schwellspannung abgeleitet wird und
der Schwellwert oder die Schwellspannung für den Vergleich mit einem Messwert oder mit einer Spannung gespeichert wird.

## Claims

1. Voltage testing device for testing a voltage between a conductive liquid and a location of an operator with
an operator junction (3) with at least one conductive area by which the voltage testing device can be electrically connected to the body of the operator during operation, preferably to his/her hand, and
a liquid junction (1) with at least one conductive area by which the voltage testing device can be electrically connected to the liquid during operation,
wherein during operation the voltage to be tested causes a current flow through the device and the body of the operator,
**characterized in that** the edges of the electrically conductive area of the operator junction (3) and the conductive are of the liquid junction (1) closest to each other have a distance of at least 0.50 m.

2. Voltage testing device according to claim 1,
**characterized in that** at least one electric resistor (12, 13, 14) is connected between the liquid junction (1) and the operator junction (3),
and the device comprises a device for electrically measuring a voltage via the resistor (12, 13, 14) or via part of the resistor (14) or a device for electrically comparing said voltage with a threshold voltage.

3. Voltage testing device according to claim 2,
**characterized in that** the electric resistor (12, 13, 14) between the liquid junction (1) and the operator junction (3) is chosen at least so large that the current in the operator junction (3) is limited to 1 mA or less when a maximum nominal voltage occurs between the conductive liquid and the location of the operator.

4. Voltage testing device according to claim 3, **characterized in that** the electric resistor (12, 13, 14) is divided into at least two individual resistors (12, 13, 14), each of which having a size which limits the current in the operator junction (3) to 1 mA or less when a maximum nominal voltage occurs between the conductive liquid and the location of the operator.

5. Voltage testing device according to claim 3 or 4,
**characterized in that** it comprises an analog-to-digital converter and a digital evaluator (17),
wherein the analog-to-digital converter is interconnected in such a way that the current can be detected and digitalized via the resistor (12, 13, 14) or via part of the resistor during operation and one or more measured values is/are available to the digital evaluator.

6. Voltage testing device according to claim 5,
**characterized in that** the evaluator is configured in such a way that during operation a comparison between the voltage measured value and a threshold value takes place.

7. Voltage testing device according to claim 6,
**characterized in that** the threshold value is adjustable.

8. Voltage testing device according to one of claims 6 or 7,
**characterized in that** the voltage testing device comprises a warning device (10, 11) which issues a warning signal during operation if the voltage measured value exceeds the threshold value in the direction which corresponds to a higher voltage throughout the resistor (12, 13, 14) or throughout part of the resistor (14).

9. Voltage testing device according to one of claims 3 to 8,
**characterized in that** a rectifier (15) is switched in the current path of the liquid junction (1) to the operator junction (3).

10. Voltage testing device according to claim 1,
**characterized in that** it comprises a function for self-testing with which at least one function of the voltage testing device can be tested.

11. Voltage testing device according to one of the preceding claims,
**characterized in that** it comprises measurement indicators (7, 8) for a charging status of a battery.

12. Method for testing a voltage between a conductive liquid and a location of an operator, wherein during testing a liquid junction (1) with at least one conductive area is connected to the liquid to be tested and an operator junction (3) with at least one conductive area is connected to the operator, in particular to his/her hand,
after connecting a current flows through an electric connection (12, 13, 14) between the liquid junction (1) and the operator junction (3) and through the body of the operator, **characterized in that** the distance of the edges of the conductive area of the liquid junction (1) and the conductive area of the operator junction (3) closest to each other is 0.50 m.

13. Method according to claim 12, **characterized in that** the electric current is electrically measured via the resistor (12, 13, 14) or via part of the resistor (14) and the measured value is compared to a threshold value or said voltage is compared with a threshold voltage by means of an electronic circuit.

14. Method according to claim 12 or 13, **characterized in that**
the threshold value or the threshold voltage is determined in a calibration procedure, during the calibration procedure a known potential is applied to the liquid junction (1), the voltage is measured via the resistor (12, 13, 14) or via part of the resistor (14),
the threshold value or the threshold voltage is derived therefrom, and
the threshold value or the threshold voltage is stored for comparison with a measured value or with a voltage.

## Revendications

1. Dispositif de contrôle de la tension pour contrôler une tension entre un liquide conducteur et un endroit où se trouve un opérateur, avec un endroit de raccordement à l'opérateur (3) avec au moins une zone conductrice à laquelle, en fonctionnement, le dispositif de contrôle puisse être raccordé électriquement au corps de l'opérateur, de préférence à sa main, et
un endroit de raccordement au liquide (1) avec au moins une zone conductrice à laquelle, en fonctionnement, le dispositif de contrôle puisse être raccordé électriquement au liquide,
en fonctionnement, la tension à contrôler engendrant un courant passant par le dispositif et le corps de l'opérateur,
**caractérisé en ce que** les bords les plus proches l'un de l'autre respectivement de la zone électriquement conductrice de l'endroit de raccordement à l'opérateur (3) et de la zone électriquement conductrice de l'endroit de raccordement au liquide (1) présentent une distance l'un de l'autre d'au moins 0,50 m.

2. Dispositif de contrôle de la tension selon la revendication 1,
**caractérisé en ce qu'**une résistance électrique (12, 13, 14) est branchée entre l'endroit de raccordement au liquide (1) et l'endroit de raccordement à l'opérateur (3) et **en ce que** le dispositif comprend des moyens pour mesurer électriquement une tension à la résistance (12, 13, 14) ou à une partie de la résistance (14) ou des moyens pour comparer électriquement cette tension avec une tension seuil.

3. Dispositif de contrôle de la tension selon la revendication 1 ou 2,
**caractérisé en ce que** la résistance électrique (12, 13, 14) entre l'endroit de raccordement au liquide (1) et l'endroit de raccordement à l'opérateur (3) est choisie au moins si grande que, pour une tension nominale maximale entre le liquide conducteur et l'endroit où se trouve l'opérateur, le courant passant dans l'endroit de raccordement à l'opérateur (3) soit limité à 1 mA ou moins.

4. Dispositif de contrôle de la tension selon la revendication 3,
**caractérisé en ce que** la résistance électrique (12, 13, 14) est divisée en au moins deux résistances individuelles (12, 13, 14) dont chacune présente une valeur qui, pour une tension nominale maximale entre le liquide conducteur et l'endroit où se trouve l'opérateur, limite le courant passant dans l'endroit de raccordement à l'opérateur (3) à 1 mA ou moins.

5. Dispositif de contrôle de la tension selon la revendication 3 ou 4,
**caractérisé en ce qu'**il comprend un convertisseur analogique-numérique et des moyens d'exploitation numériques (17),
le convertisseur analogique-numérique étant raccordé de façon que, en fonctionnement, la tension à la résistance (12, 13, 14) ou à une partie de la résistance puisse être captée et numérisée et **en ce qu'**une ou plusieurs valeurs de mesure sont disponibles pour les moyens d'exploitation numériques.

6. Dispositif de contrôle de la tension selon la revendication 5,
**caractérisé en ce que** les moyens d'exploitation sont configurés de façon que, en fonctionnement, une comparaison entre la valeur mesurée de tension et une valeur seuil soit effectuée.

7. Dispositif de contrôle de la tension selon la revendication 6,
**caractérisé en ce que** la valeur seuil est ajustable.

8. Dispositif de contrôle de la tension selon l'une des revendications 6 ou 7, **caractérisé en ce que** le dispositif de contrôle de la tension comprend des moyens d'alerte (10, 11) qui émettent, en fonctionnement, un signal d'alerte lorsque la valeur mesurée de tension dépasse la valeur seuil dans le sens qui correspond à une tension plus grande à la résistance (12, 13, 14) ou à une partie de la résistance (14).

9. Dispositif de contrôle de la tension selon l'une des revendications 3 à 8, **caractérisé en ce qu'**un redresseur (15) est branché dans le trajet de courant allant de l'endroit de raccordement au liquide (1) à l'endroit de raccordement à l'opérateur (3).

10. Dispositif de contrôle de la tension selon la revendication 1,
**caractérisé en ce qu'**il comprend une fonction d'autotest à l'aide de laquelle au moins une fonction du dispositif de contrôle de la tension peut être testée.

11. Dispositif de contrôle de la tension selon l'une des revendications précédentes, **caractérisé en ce qu'**il comprend un moyen d'affichage (7, 8) de l'état de charge d'une batterie.

12. Procédé pour contrôler une tension entre un liquide conducteur et un endroit où se trouve un opérateur,
selon lequel, lors du contrôle, un endroit de raccordement au liquide (1) avec au moins une zone conductrice est raccordé électriquement au liquide à contrôler et un endroit de raccordement à l'opérateur (3) avec au moins une zone conductrice est raccordé électriquement à l'opérateur, notamment à sa main,
après le raccordement, un courant passe par une connexion électrique (12, 13, 14) entre l'endroit de raccordement au liquide (1) et l'endroit de raccordement à l'opérateur (3) et par le corps de l'opérateur,
**caractérisé en ce que** les bords les plus proches l'un de l'autre respectivement de la zone électriquement conductrice de l'endroit de raccordement à l'opérateur (3) et de la zone électriquement conductrice de l'endroit de raccordement au liquide (1) présentent une distance l'un de l'autre d'au moins 0,50 m.

13. Procédé selon la revendication 12, **caractérisé en ce que** la tension électrique à la résistance (12 13, 14) ou à une partie de la résistance (14) est mesurée électriquement et **en ce que** la valeur mesurée est comparée à une valeur seuil ou que cette tension est comparée à une tension seuil par un circuit électronique.

14. Procédé selon la revendication 12 ou 13, **caractérisé en ce que** la valeur seuil ou la tension seuil est déterminée lors d'un procédé de calibrage, un potentiel connu étant appliqué à l'endroit de raccordement au liquide (1),
la tension à la résistance (12, 13, 14) ou à une partie de la résistance (14) est mesurée,
la valeur seuil ou la tension seuil en est déduite et
la valeur seuil ou la tension seuil est enregistrée pour la comparaison à une valeur mesurée ou à une tension.
